(19) Europäisches Patentamt
European Patent Office
Office européen des brevets

(11) **EP 3 039 486 B1**

(12) **FASCICULE DE BREVET EUROPEEN**

(45) Date de publication et mention de la délivrance du brevet:
**10.04.2019 Bulletin 2019/15**

(51) Int Cl.:
*G03F 7/20* (2006.01)          *H01J 37/317* (2006.01)
*H01J 37/285* (2006.01)      *H01J 37/304* (2006.01)

(21) Numéro de dépôt: **14767056.6**

(22) Date de dépôt: **28.08.2014**

(86) Numéro de dépôt international:
**PCT/FR2014/052139**

(87) Numéro de publication internationale:
**WO 2015/028753 (05.03.2015 Gazette 2015/09)**

(54) **PROCÉDÉ DE CORRECTION DES EFFETS DE PROXIMITÉ ÉLECTRONIQUE**

VERFAHREN ZUR KORREKTUR VON ELEKTRONENNÄHEEFFEKTEN

METHOD FOR CORRECTING PROXIMITY EFFECTS CAUSED BY ELECTRONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.08.2013 FR 1302001**

(43) Date de publication de la demande:
**06.07.2016 Bulletin 2016/27**

(73) Titulaire: **Aselta Nanographics**
**38000 Grenoble (FR)**

(72) Inventeurs:
• **JEDIDI, Nader**
  **CH-1004 Lausanne (CH)**
• **SCHIAVONE, Patrick**
  **F-38190 Villard Bonnot (FR)**
• **TORTAI, Jean-Hervé**
  **F-38700 La Tronche (FR)**
• **FIGUEIRO, Thiago**
  **F-38000 Grenoble (FR)**

(74) Mandataire: **Talbot, Alexandre**
**Cabinet Hecké**
**28 Cours Jean Jaurès**
**38000 Grenoble (FR)**

(56) Documents cités:
**EP-A1- 2 560 187          US-A- 6 035 113**
**US-A1- 2003 093 767      US-A1- 2006 183 025**
**US-A1- 2007 194 250      US-A1- 2008 067 446**
**US-A1- 2010 237 469**

**Description**

**Domaine technique de l'invention**

L'invention est relative aux domaines utilisant l'interaction d'un faisceau d'électrons avec une cible, notamment les domaines de la lithographie électronique, et de la microscopie électronique.

**État de la technique**

L'interaction d'un faisceau d'électrons avec une cible solide est un phénomène physique qui est mis à profit dans plusieurs domaines techniques. La lithographie électronique, par exemple, utilise un faisceau d'électrons pour réaliser un motif sur un substrat. Cette technique a permis une amélioration de la résolution spatiale des motifs réalisés sur un substrat, contribuant ainsi à la miniaturisation des circuits intégrés. En outre, un bombardement électronique peut également être utilisé pour l'analyse d'une cible solide. Selon le type d'analyse souhaitée, un faisceau d'électrons ayant une énergie et une dose prédéterminés peut être utilisé comme faisceau incident. Dès lors, la quantification des émissions radiatives et/ou corpusculaires permet par exemple de déterminer la topographie, la composition, la cathodoluminescence, etc. de la cible bombardée par le faisceau d'électrons incident.

Pour une meilleure exploitation de l'interaction d'un faisceau électronique avec une cible, une modélisation précise de cette interaction est alors nécessaire. Par ailleurs, lors du bombardement d'une cible solide avec un faisceau d'électrons, des phénomènes physiques qualifiés d'effets de proximité, ou effets de diffusion, peuvent altérer la qualité de cette modélisation.

Les effets de proximité sont engendrés par les effets de diffusion vers l'avant et de rétrodiffusion des électrons autour de la trajectoire initiale (les effets de « forward scattering » et de « back scattering » selon la terminologie anglo-saxonne). Les effets de proximité dépendent notamment de la composition ainsi que de la géométrie de la cible, et des caractéristiques du faisceau d'électrons. Ainsi, il est nécessaire de tenir compte des effets de proximité pour obtenir une modélisation fidèle et précise de l'interaction du faisceau électronique avec la cible.

Une fonction dite d'étalement du point ou PSF (PSF pour l'abréviation anglaise de « Point Spread Function ») est généralement utilisée, notamment pour tenir compte des effets de proximité. Une fonction PSF peut décrire, par exemple, la variation de la dose (i.e. quantité d'énergie par unité de surface) reçue en un point de la cible en fonction de la distance r séparant ce point du point d'incidence du faisceau électronique.

Dans le domaine de la lithographie électronique, la dose déposée dans la cible est alors calculée par la convolution de la fonction PSF avec la forme géométrique définissant le motif à réaliser.

Une des fonctions PSF les plus utilisées est une combinaison d'une première gaussienne modélisant l'effet de la diffusion vers l'avant, et une deuxième gaussienne modélisant la rétrodiffusion.

La fonction PSF classique à base de gaussiennes est représentée par la fonction suivante :

$$f(r) = \frac{1}{\pi(1+\eta)} \left( \frac{1}{\alpha^2} e^{-r^2/\alpha^2} + \frac{\eta}{\beta^2} e^{-r^2/\beta^2} \right) \qquad (1)$$

où $\alpha$ représente la largeur du rayonnement diffusé vers l'avant, $\beta$ représente la largeur du rayonnement rétrodiffusé, $\eta$ représente le rapport entre les intensité des rayonnements direct et rétrodiffusé, et r représente la position radiale d'un point par rapport au point d'incidence du faisceau électronique.

Les paramètres $\alpha$, $\beta$ et $\eta$ peuvent être déterminés expérimentalement. Ces paramètres dépendent des caractéristiques du faisceau électronique et de la nature de la cible.

En utilisant la fonction PSF donnée par l'équation 1, on observe des écarts très significatifs entre la distribution d'énergie autour du point d'impact donnée par cette fonction PSF et celle obtenue par des mesures expérimentales ou en utilisant une simulation Monte-Carlo, qui est un des modèles références.

Par ailleurs, la demande de brevet américain US2008/0067446 divulgue un procédé de lithographie électronique comportant une étape de correction des effets de proximité. La fonction PSF utilisée dans ce procédé comprend une combinaison d'au moins trois gaussiennes, pouvant avoir des coefficients de pondération négatifs.

**Objet de l'invention**

Dans certains domaines techniques, notamment celui de la lithographie électronique et de la microscopie électronique, on aurait besoin d'un procédé de projection d'un faisceau d'électrons précis et facile à réaliser.

On tend à satisfaire ce besoin en prévoyant un procédé de projection d'un faisceau électronique sur une cible comprenant une correction des effets de diffusion des électrons dans la cible. La correction comporte une étape de calcul d'une fonction d'étalement du point ayant une variation radiale suivant une fonction polynomiale par morceaux.

Avantageusement, la correction des effets de diffusion des électrons dans la cible comporte une modulation de la dose déposée dans la cible et/ou de la géométrie de la portion de la cible recevant le faisceau électronique.

De manière préférentielle, la variation radiale de la fonction d'étalement du point est un polynôme cubique par morceaux. Avantageusement, cette variation radiale est définie sur un intervalle [a , b] appartenant à l'ensemble des nombres réels $\mathbb{R}$, et satisfait aux conditions limites dites naturelles de manière que les dérivées secondes de la variation radiale aux extrémités de l'intervalle [a , b] soient nulles.

Selon un mode de réalisation, la fonction polynomiale par morceaux est définie par des coefficients ($\alpha_{i,j}$), lesdits coefficients étant choisis de manière à optimiser l'interpolation du résultat d'une simulation probabiliste de référence de la diffusion des électrons provenant du faisceau électronique dans la cible, par la variation radiale de la fonction d'étalement du point.

Selon un autre mode de réalisation, lesdits coefficients ($\alpha_{i,j}$) sont choisis de manière à optimiser l'interpolation de résultats expérimentaux représentant la diffusion des électrons provenant du faisceau électronique dans la cible, par la variation radiale de la fonction d'étalement du point.

On prévoit également un dispositif de lithographie électronique comportant :

- un module d'accélération et de projection d'un faisceau électronique sur une cible ;
- un module de calcul configuré pour corriger les effets de diffusion des électrons dans ladite cible ;

dans lequel le module de calcul est configuré pour calculer une fonction d'étalement du point ayant une variation radiale sous forme d'une fonction polynomiale par morceaux de manière à optimiser la distribution de la dose déposée dans la cible et/ou la géométrie de la portion de la cible recevant le faisceau électronique.

De manière avantageuse, le module de calcul du dispositif de lithographie électronique est configuré pour optimiser la distribution de la dose déposée dans la cible, par un calcul comportant une convolution de la fonction d'étalement du point et de la géométrie du motif à graver.

En outre, on prévoit un dispositif de microscopie électronique comportant :

- un module d'accélération et de projection d'un faisceau électronique incident sur une cible ;
- un module d'affichage d'un signal décrivant la cible ;
- un calculateur configuré pour optimiser une fonction d'étalement du point globale à partir de la correction des effets de diffusion des électrons incidents dans la cible, la correction des effets de diffusion des électrons incidents dans la cible comportant une étape de calcul d'une fonction d'étalement du point additionnelle ayant une variation radiale suivant une fonction polynomiale par morceaux ; et
- un module de traitement du signal réémis résultant de l'interaction du faisceau électronique incident avec la cible, le module étant configuré pour corriger le signal décrivant la cible en utilisant un calcul de déconvolution du signal réémis par la cible et ladite fonction d'étalement du point globale.

## Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, le tracé de la variation radiale $PSF_{réf}(r)$ d'une fonction d'étalement du point de référence $PSF_{réf}$ calculée à l'aide d'une simulation Monte-Carlo ;
- la figure 2 représente, des tracés d'ajustement de la fonction $PSF_{réf}(r)$ par deux fonctions définies respectivement par une combinaison de quatre et de six gaussiennes ;
- la figure 3 représente, une comparaison de deux tracés d'ajustement de la fonction $PSF_{réf}(r)$ par une fonction définie par la combinaison de quatre gaussiennes, et une fonction spline cubique naturelle.

## Description de modes de réalisation préférentiels de l'invention

Une utilisation maîtrisée d'un faisceau d'électrons incident sur une cible nécessite la prise en compte des différents phénomènes physiques générés par cette interaction, notamment les effets de proximité électronique.

Pour une modélisation précise et facilement réalisable de l'interaction d'un faisceau d'électrons avec une cible, il est particulièrement avantageux d'utiliser une fonction d'étalement du point (PSF) paramétrable et rapidement calculable. Il est également avantageux que la fonction PSF soit choisie de manière à être la plus réaliste possible, en ajustant (en réalisant un « fit » en terminologie anglo-saxonne) par exemple des résultats expérimentaux et/ou un des modèles références, par exemple celui utilisant une méthode de Monte-Carlo.

On tend vers cet objectif, en choisissant une classe de fonctions PSF dont la variation radiale est une fonction polynomiale par morceaux, communément appelée « spline ».

Selon un premier mode de mise oeuvre, un procédé de projection d'un faisceau électronique sur une cible comporte une correction des effets de diffusion des électrons dans la cible, autrement dit les effets de proximité.

Pour réaliser la correction des effets de diffusion, une fonction d'étalement du point, ou fonction PSF, est tout d'abord calculée. La fonction PSF calculée est configurée pour corriger la distribution d'énergie déposée dans la cible en tenant compte des effets dits de proximité.

Par ailleurs, la fonction PSF tient compte également de la composition de la cible. Par composition de la cible, on entend la nature des couches de l'empilement formant la cible destinée à être bombardée par le faisceau électronique.

Selon ce mode de mise en oeuvre, la fonction d'étalement du point utilisée est avantageusement une fonction polynomiale par morceaux, autrement dit une spline. La fonction PSF est alors définie par un polynôme par morceaux. Ce type de fonction est, de manière avantageuse, facilement paramétrable et peut réaliser une interpolation précise d'un ensemble de points expérimentaux.

A titre d'exemple, on peut considérer un ensemble de k points expérimentaux discrets, $(r_i, f(r_i) = y_i)$ à interpoler ou à ajuster, où i est un indice entier variant de 1 à k, k étant un entier supérieur ou égal à 3. Les k points $(r_i, f(r_i))$ sont définis dans un intervalle [a, b] de l'ensemble des réels $\mathbb{R}$. L'intervalle [a , b] est ainsi divisé en (k-1) sous intervalles $[r_i, r_{i+1}]$.

Chaque réel $r_i$ d'indice i est défini de manière à satisfaire les égalités et les inégalités suivantes :

$$r_1 = a \ < r_2 < \cdots < r_k = b \qquad (2)$$

Une fonction polynomiale par morceaux ou spline s(r), est définie comme suit :

$$s(r) = p_i(r)_{|[r_i, r_{i+1}]} \quad pour \ i = 1, \dots, k-1 \qquad (3)$$

où, $p_i(r)$ est un polynôme de degré l. La spline s(r) est ainsi dite de degré l, et elle est de ce fait de classe $C^{l-1}$ sur l'intervalle [a , b].

Le polynôme $p_i(r)$ peut s'écrire selon la formule suivante :

$$p_i(r) = \alpha_{i,0} \ r^0 + \alpha_{i,1} \ r^1 + \cdots + \alpha_{i,(l-1)} \ r^{l-1} + \alpha_{i,l} \ r^l \qquad (4)$$

Chaque polynôme $p_i(r)$ comporte (l+1) coefficients $\alpha_{i,j}$, où j est un entier variant de 0 à l. Ainsi, pour définir la spline s(r) il faut déterminer (k-1).(l+1) coefficients $\alpha_{i,j}$. Ainsi, la fonction polynomiale par morceaux est définie par des coefficients $(\alpha_{i,j})$.

Par ailleurs, une fonction spline est définie de manière à respecter les conditions de « collocation » aux bords des sous intervalles $[r_i, r_{i+1}]$. Ces conditions sont les suivantes :

$$p_i(r_i) \quad = \ y_i \qquad\qquad pour \ i = 1, \dots, k-1 \qquad\qquad (5)$$

$$p_i(r_{i+1}) \quad = \ y_{i+1} \qquad\qquad pour \ i = 1, \dots, k-1 \qquad\qquad (6)$$

$$p_i^{(j)}(r_{i+1}) = \ p_{i+1}^{(j)}(r_{i+1}) \quad pour \ i = 1, \dots, k-2 \ et \ j = 1, \dots, l-1 \qquad (7)$$

Ces conditions de « collocation » permettent d'obtenir (2.(k-1) + (k-2).(l-1)) équations linéaires avec les différents coefficients $\alpha_{i,j}$ des polynômes $p_i(r)$.

Or, pour définir la spline s(r) il faut déterminer tous les coefficient $\alpha_{i,j}$, avec i variant de 1 à k-1 et j variant de 0 à l. Pour pouvoir déterminer tous les coefficients $\alpha_{i,j}$ de la spline s(r), il faut (k-1).(l+1) équations linéaires. De ce fait, il manque (l-1) équations linéaires supplémentaires.

Les équations manquantes sont généralement données par les conditions limites imposées à la fonction spline s(r).

Avantageusement, les conditions limites permettent d'obtenir une solution unique, définissant de ce fait la fonction spline. Ainsi, pour une opération d'ajustement de points expérimentaux ($(r_m, y_m)$ pour m = 1,...,n), les variables à optimiser sont les valeurs de $r_i$ choisies parmi l'ensemble des n points expérimentaux ($r_m, y_m$) à ajuster. Par ailleurs, les fonctions spline, permettent de manière avantageuse une interpolation précise des valeurs expérimentales, et elles sont facilement paramétrables et calculables.

Selon un mode particulier de mise en oeuvre, la correction des effets de diffusion des électrons dans la cible comporte une modulation de la dose déposée dans la cible.

En effet, après avoir calculé une PSF ayant une variation radiale suivant une fonction polynomiale par morceaux, la distribution de la dose déposée dans la cible peut alors être calculée en corrigeant les effets de diffusion des électrons dans la cible.

A titre d'exemple, dans le domaine de la lithographie électronique, la correction de la distribution de la dose déposée est déterminée par la convolution de la PSF et la forme géométrique du motif à graver.

Selon un autre mode de mise en oeuvre, la correction des effets de diffusion des électrons dans la cible comporte une modulation de la géométrie de la portion de la cible recevant le faisceau électronique. Ainsi, on peut moduler la dose déposée et/ou la géométrie de la cible recevant le faisceau électronique pour obtenir avec précision la distribution spatiale souhaitée de la dose déposée dans la cible.

Ces modes de réalisation du procédé décrits ci-dessus peuvent être avantageusement utilisés dans un procédé de lithographie électronique pour corriger la dose déposée dans une couche de résine électronique. Une telle correction permet de manière avantageuse d'augmenter la résolution spatiale et/ou la fidélité au motif attendu et avantageusement des motifs développés à partir de ladite résine bombardée par le faisceau électronique en contrôlant avec précision leur forme et leur dimension.

Par ailleurs, les fonctions de type spline sont facilement paramétrables et calculables. Ainsi, l'utilisation d'une spline comme une fonction PSF permet de manière avantageuse de faciliter la réalisation d'un procédé de projection d'un faisceau électronique sur une cible tout en corrigeant les effets de diffusion des électrons dans la cible.

Avantageusement, la variation radiale de la fonction d'étalement du point est un polynôme cubique par morceaux de classe $C^2$.

Par ailleurs, pour déterminer tous les coefficients d'une spline cubique s(r) définie sur l'intervalle [a , b], on a besoin de deux équations linéaires imposées par des conditions de bord (en r=a et r=b), en plus des conditions de « collocation ».

Il existe trois types de conditions de bord usuelles pour les splines cubiques : les conditions de Hermite, les conditions périodiques et les conditions naturelles. Les conditions de Hermite imposent les conditions suivantes :

$$s'(a) = f'(a) \quad et \ s'(b) = f'(b) \tag{8}$$

où $f'(r)$ représente la dérivée de la fonction $f(r)$ que la spline s(r) cherche à interpoler. Ces conditions supposent que $f'(a)$ et $f'(b)$ sont connues.

Les conditions périodiques imposent les conditions suivantes :

$$s'(a) = s'(b) \quad et \ s''(a) = s''(b) \tag{9}$$

Avantageusement, la fonction d'étalement du point est définie sur un intervalle [a, b] appartenant à l'ensemble des nombres réels $\mathbb{R}$, et elle satisfait aux conditions limites dites naturelles. Autrement dit, la dérivée seconde de la fonction d'étalement du point est nulle aux bords de l'intervalle [a, b] :

$$s''(a) = s''(b) \ = 0 \tag{10}$$

Imposer des conditions limites dites naturelles à une spline cubique, permet de manière avantageuse d'obtenir une spline n'ayant pas de courbures aux bords de l'intervalle [a , b]. En outre, ce type de conditions limites n'exige aucune connaissance des dérivées de la fonction à interpoler.

Par ailleurs, les fonctions de type spline permettent de manière avantageuse une flexibilité pour ajuster une courbe donnée. Ainsi, pour qu'une fonction PSF permette une correction des effets de diffusion, il est plus avantageux d'utiliser une variation radiale de la PSF suivant une spline qu'une combinaison de gaussiennes ou autre type de fonction.

Selon un mode de réalisation, la fonction polynomiale par morceaux est définie par des coefficients ($\alpha_{i,j}$) et les coefficients sont choisis de manière à optimiser l'interpolation du résultat d'une simulation de référence de la diffusion des électrons provenant du faisceau électronique dans la cible, par la variation radiale de la fonction d'étalement du point.

Par ailleurs, une simulation de type probabiliste a été réalisée pour calculer une fonction d'étalement du point référence $PSF_{réf}$. Cette dernière peut également être utilisée pour tester la « flexibilité » d'ajustement d'une spline. Une simulation Monte-Carlo, de la diffusion des électrons provenant d'un faisceau électronique dans une cible, a été réalisée pour calculer la fonction $PSF_{réf}$. Ensuite, la variation radiale $PSF_{réf}(r)$ de la fonction $PSF_{réf}$ a été interpolée par une fonction de type spline et une combinaison de gaussiennes. Par ailleurs, la fonction d'étalement du point référence $PSF_{réf}$ peut être déterminée à partir des mesures. Ainsi, l'ajustement par les fonctions de type spline et la combinaison de gaussiennes peut être réalisé en se basant sur ces mesures.

Une interaction d'un faisceau d'électrons d'un diamètre d'environ 30 nm généré par une tension d'accélération de 100 kV, a été étudiée. Dans cet exemple, le faisceau électronique interagit avec un empilement configuré pour former un masque de lithographie en extrême ultraviolet. L'empilement comporte successivement, un substrat en oxyde de silicium, une couche de siliciure de molybdène, et une couche de résine électronique configurée pour être bombardée par le faisceau électronique.

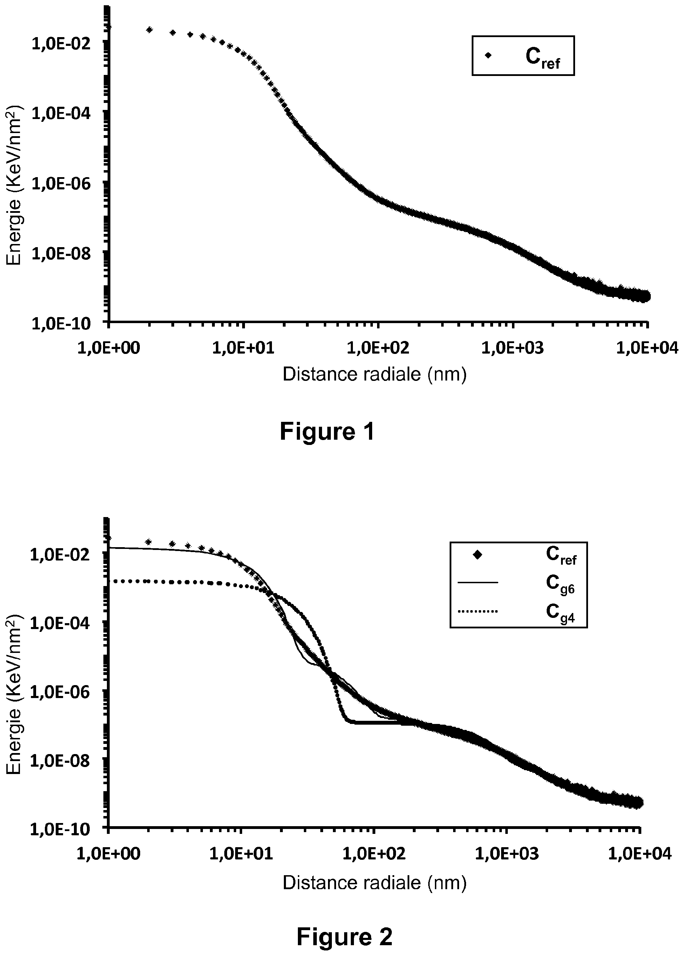

La figure 1 illustre la variation radiale d'une fonction d'étalement du point de référence $PSF_{réf}(r)$ calculée à l'aide d'une simulation Monte-Carlo. Cette fonction $PSF_{réf}(r)$ représente, en échelle logarithmique, le profil de la variation radiale de la dose déposée dans l'empilement décrit ci-dessus en fonction du rayon r correspondant à la distance du point d'incidence du faisceau électronique.

La figure 2 illustre une interpolation ou une approximation de la fonction $PSF_{réf}(r)$ par une fonction g(r) composée d'une combinaison de gaussiennes. La fonction g(r) peut avoir comme formule :

$$g(r) \;=\; \frac{1}{\pi(1+\sum_{1\le i\le n}\eta_i)} \left( k^2\, e^{-k^2 r^2} \;+\; \sum_{1\le i\le n} \eta_i\, k_i^2\, e^{-k_i^2 r^2} \right) \qquad (11)$$

où k, $\eta_i$ et $k_i$ constituent les paramètres à optimiser pour obtenir la meilleure interpolation de la $PSF_{réf}(r)$ par la combinaison de gaussiennes g(r).

Par ailleurs, l'optimisation des paramètres k, $\eta_i$ et $k_i$ pour l'interpolation de la fonction $PSF_{réf}(r)$ peut être réalisée par tout algorithme connu pouvant être utilisé pour une optimisation locale ou globale. A titre d'exemple, on peut utiliser l'algorithme de « Levenberg-Marquardt », l'algorithme du « simplexe », l'algorithme de « krigeage » ou encore des méthodes basées sur des algorithmes génétiques.

Le tracé de la figure 2 comporte des courbes $C_{ref}$, $C_{g4}$ et $C_{g6}$ correspondant respectivement à la fonction $PSF_{réf}(r)$, une fonction $g_4(r)$ composée d'une combinaison de quatre gaussiennes, et une fonction $g_6(r)$ composée d'une combinaison de six gaussiennes. On observe clairement, que malgré l'utilisation de plusieurs gaussiennes, la fonction g(r) n'arrive pas à produire une interpolation fidèle à la fonction d'étalement du point référence $PSF_{réf}(r)$.

Tableau 1

| Nombre de gaussiennes | Nombre de variables optimisées | Erreur quadratique moyenne |
|---|---|---|
| 4 | 7 | 802 |
| 5 | 9 | 508 |
| 6 | 11 | 409 |
| 7 | 13 | 383 |

Le tableau 1 montre les résultats de l'interpolation de la fonction d'étalement du point référence $PSF_{réf}(r)$ par la fonction g(r) comportant plusieurs gaussiennes. La qualité de l'interpolation est quantifiée par le calcul d'une variante $D_s$ de l'erreur quadratique. Cette variante est estimée par la formule suivante : $D_s = \sum_j [\ln(PSF_{réf}(r_j) - \ln(g(r_j))]^2$, où $r_j$ représentent les points de la fonction $PSF_{réf}(r)$ interpolée.

Une interpolation utilisant une spline s(r) cubique avec des conditions limites naturelles a également été réalisée. En utilisant la définition d'une spline décrite ci-dessus, l'interpolation est réalisée en optimisant la distribution des $r_i$ dans l'intervalle [a, b] pour définir les (k-1) sous intervalles [$r_i$, $r_{i+1}$] formant l'intervalle [a, b]. En disposant de la fonction $PSF_{réf}(r)$ définie sur l'intervalle [a, b], et des points $r_i$ (*i.e.* des points $y_i$ correspondants $y_i = PSF_{réf}(r_i)$), l'unique spline cubique naturelle s(r) interpolant la $PSF_{réf}(r)$ peut alors être calculée.

Comme pour la fonction g(r) l'optimisation peut être réalisée à l'aide d'une optimisation locale ou globale.

Le tableau 2 résume les résultats de l'interpolation de la fonction $PSF_{réf}(r)$ par une spline cubique naturelle s(r) en variant le nombre de noeuds (k) et en optimisant la distribution des $r_i$ dans l'intervalle [a, b].

Tableau 2

| Nombre de sous intervalles (k-1) | Nombre de variables optimisées (k-2) | Erreur quadratique moyenne |
|---|---|---|
| 6 | 5 | 537 |
| 7 | 6 | 409 |
| 8 | 7 | 382 |
| 9 | 8 | 185 |

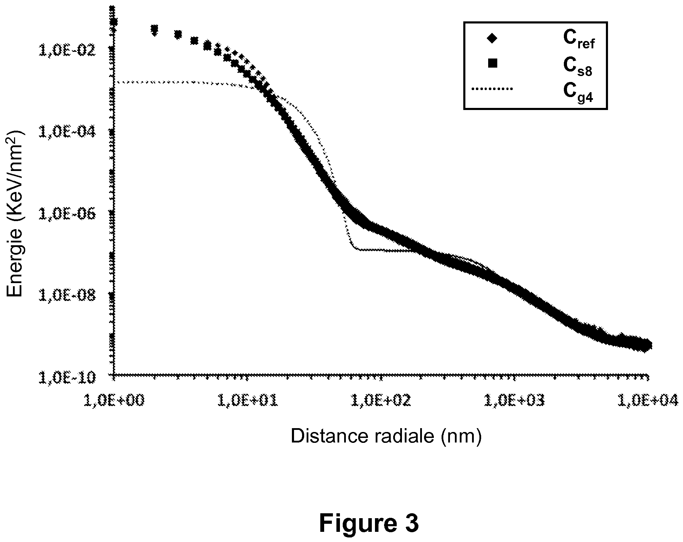

La figure 3 montre le tracé de trois courbes $C_{ref}$, $C_{g4}$ et $C_{s8}$ correspondant respectivement à la fonction $PSF_{réf}(r)$, une interpolation de la fonction $PSF_{réf}(r)$ par la fonction g(r) composée d'une combinaison de quatre gaussiennes, et une interpolation de la fonction $PSF_{réf}(r)$ par une spline cubique naturelle en utilisant neuf noeuds. On observe clairement que pour le même nombre de paramètre à optimiser (7), la fonction spline cubique naturelle permet d'avoir une meilleure interpolation de la fonction $PSF_{réf}(r)$ qu'une combinaison de quatre gaussiennes.

En outre, la comparaison des résultats des tableaux 1 et 2 montre également que les fonctions splines cubiques naturelles permettent de manière avantageuse une meilleure interpolation que les fonctions à base d'une combinaison de gaussiennes. En effet, pour un même nombre de paramètre à optimiser pour interpoler la fonction $PSF_{réf}(r)$, la variante $D_s$ de l'erreur quadratique est plus faible pour les splines que pour la combinaison de gaussiennes.

Pour une interpolation avec une spline cubique naturelle en utilisant 8 intervalles, autrement dit, en optimisant respectivement 7 coefficients, l'erreur quadratique est 48% plus faible en comparaison avec une interpolation avec une combinaison de quatre gaussiennes ($g_4(r)$).

Dans une variante de réalisation, la fonction polynomiale par morceaux est définie par des coefficients ($\alpha_{i,j}$) et les coefficients sont choisis de manière à optimiser l'interpolation des résultats expérimentaux représentant la diffusion des électrons provenant du faisceau électronique dans la cible, par la variation radiale de la fonction d'étalement du point. Dans certains cas, les mesures ne sont pas des mesures directes de la diffusion, on utilise alors par exemple des mesures dimensionnelles.

Une variation radiale de la fonction d'étalement du point de type fonction polynomiale par morceaux est, avantageusement, facile à paramétrer et à calculer. En outre, une fonction polynomiale par morceaux permet une interpolation plus précise qu'une interpolation par une combinaison de gaussiennes, et en utilisant un nombre limité de paramètres à optimiser. En outre, il est plus facile de calculer une convolution ou une déconvolution à partir de fonctions polynomiales qu'à partir de fonctions gaussiennes. Ce qui facilite les calculs pour la correction des effets de diffusion des électrons dans une cible.

Pour une utilisation maîtrisée d'un faisceau d'électrons incident sur une cible dans un système de lithographie, on prévoit un dispositif de lithographie couplé avantageusement à un module de calcul configuré pour corriger les effets de diffusion des électrons dans une cible.

Selon un mode de réalisation, un dispositif de lithographie électronique comporte un module d'accélération et de projection d'un faisceau électronique sur une cible. Le module d'accélération et de projection est avantageusement couplé à un module de calcul configuré pour corriger les effets de diffusion des électrons dans ladite cible. Préférentiellement, le module de calcul est compris dans le dispositif de lithographie. Par ailleurs, ledit module de calcul peut être indépendant dudit dispositif.

Le module de calcul est configuré pour calculer une fonction d'étalement du point ayant une variation radiale suivant une fonction polynomiale par morceaux. Ce calcul est réalisé de sorte à optimiser la distribution de la dose déposée dans la cible et/ou la géométrie de la cible recevant le faisceau électronique.

L'optimisation de la distribution de la dose déposée peut être réalisée par une opération mathématique de convolution de la fonction d'étalement du point et d'une fonction représentant la forme géométrique du motif à graver. Autrement dit, une fonction définissant un motif d'une architecture globale qu'on cherche à réaliser à partir de la cible. Avantageusement, la fonction d'étalement du point implémentée dans le module de calcul est une fonction polynomiale cubique par morceaux.

Selon un exemple de réalisation, un dispositif usuel de lithographie électronique de type SB 3054 de la société VISTEC™, ou EBM6000, EBM8000 de la société NuFlare, ou encore JBX3040, JBX3200 de la société Jeol peut être utilisé. Ce type de dispositif permet une projection directe d'un faisceau électronique sur un substrat, ou encore la réalisation d'un motif sur un masque. La correction de la diffusion des électrons par ce type de dispositif peut être réalisée selon l'invention, en modifiant le module de calcul de ce dispositif comportant, notamment le logiciel de modulation de la dose distribuée dans la cible.

On peut modifier par exemple le module de calcul utilisant le logiciel de marque PROXECCO™ distribuée par la société VISTEC™, ou le logiciel Inscale™ distribuée par la société Aselta Nanographics™. La modification de ces modules de calcul consiste notamment à remplacer la fonction PSF de la rétrodiffusion de l'art antérieur par la PSF ayant une variation radiale suivant une spline et qui est décrite ci-dessus.

La correction de la diffusion des électrons est alors réalisée par une modulation de la dose déposée dans la cible, et/ou de la géométrie de la cible recevant le faisceau électronique. Cette modulation peut comporter une étape de calcul par convolution de la spline définissant la PSF, par exemple une spline cubique naturelle, et une fonction décrivant la géométrie du motif à graver.

Le module de calcul peut également être adapté pour réaliser une simulation d'une ou plusieurs étapes d'un procédé de lithographie électronique. En outre, ce module de calcul peut être avantageusement utilisé dans un procédé d'analyse d'une cible solide en utilisant le faisceau électronique comme un faisceau incident. L'analyse d'un signal réémis par la cible et résultant de l'interaction entre la cible et le faisceau incident peut alors fournir des informations notamment sur la topographie ou la composition de la cible.

Ainsi, pour une utilisation optimisée d'un faisceau d'électrons incident sur une cible dans un système d'analyse de la cible, on prévoit un dispositif de microscopie électronique comportant en outre un calculateur configuré pour corriger la diffusion des électrons dans la cible.

Selon un mode de réalisation particulier, un dispositif de microscopie électronique comporte un module d'accélération et de projection d'un faisceau électronique incident sur une cible, et un module d'affichage d'un signal décrivant la cible.

Par ailleurs, le dispositif peut être un dispositif de microscopie électronique, à balayage, à effet de champ ou à effet tunnel, ou tout autre dispositif pouvant être utilisé en imagerie ou pour réaliser une analyse, notamment d'un échantillon d'un substrat ou d'un masque.

Le dispositif de microscopie électronique comporte en outre un calculateur configuré pour optimiser une fonction d'étalement du point globale du dispositif à partir de la correction des effets de diffusion des électrons dans la cible. Avantageusement, cette correction des effets de diffusion des électrons incidents dans la cible comporte une étape de calcul d'une fonction d'étalement du point additionnelle ayant une variation radiale suivant une fonction polynomiale par morceaux.

Afin d'obtenir un signal décrivant avec précision les caractéristiques de la cible, le dispositif est muni d'un module de traitement du signal réémis résultant de l'interaction du faisceau électronique incident avec la cible.

Avantageusement, le module de traitement du signal est configuré pour corriger le signal décrivant la cible à partir du signal réémis et la fonction d'étalement du point globale optimisée. Généralement, la correction est réalisée par une déconvolution du signal réémis par la cible et ladite fonction d'étalement globale.

## Revendications

1. Procédé de projection d'un faisceau électronique sur une cible comprenant une correction des effets de diffusion des électrons dans la cible, **caractérisé en ce que** ladite correction comporte une étape de calcul d'une fonction d'étalement du point ayant une variation radiale suivant une fonction polynomiale par morceaux.

2. Procédé selon la revendication 1, **caractérisé en ce que** la correction des effets de diffusion des électrons dans la cible comporte une modulation de la dose déposée dans la cible.

3. Procédé selon l'une des revendications 1 et 2, **caractérisé en ce que** la correction des effets de diffusion des électrons dans la cible comporte une modulation de la géométrie de la portion de la cible recevant le faisceau électronique.

4. Procédé selon l'une des revendications 1 à 3, **caractérisé en ce que** la variation radiale de la fonction d'étalement du point est un polynôme cubique par morceaux.

5. Procédé selon la revendication 4, **caractérisé en ce que** la variation radiale de la fonction d'étalement est définie sur un intervalle [a , b] appartenant à l'ensemble des nombres réels $\mathbb{R}$, et **en ce que** la variation radiale satisfait aux conditions limites dites naturelles de manière que les dérivées secondes de la variation radiale aux extrémités de l'intervalle [a, b] soient nulles.

6. Procédé selon la revendication 1, **caractérisé en ce que** la fonction polynomiale par morceaux est définie par des coefficients ($\alpha_{i,j}$), lesdits coefficients étant choisis de manière à optimiser l'interpolation du résultat d'une simulation probabiliste de référence de la diffusion des électrons provenant du faisceau électronique dans la cible, par la variation radiale de la fonction d'étalement du point.

**7.** Procédé selon la revendication 1, **caractérisé en ce que** la fonction polynomiale par morceaux est définie par des coefficients ($\alpha_{i,j}$), lesdits coefficients étant choisis de manière à optimiser l'interpolation de résultats expérimentaux représentant la diffusion des électrons provenant du faisceau électronique dans la cible, par la variation radiale de la fonction d'étalement du point.

**8.** Dispositif de lithographie électronique comportant :

  • un module d'accélération et de projection d'un faisceau électronique sur une cible ;
  • un module de calcul configuré pour corriger les effets de diffusion des électrons dans ladite cible ;

**caractérisé en ce que** le module de calcul est configuré pour calculer une fonction d'étalement du point ayant une variation radiale sous forme d'une fonction polynomiale par morceaux de manière à optimiser la distribution de la dose déposée dans la cible et/ou la géométrie de la portion de la cible recevant le faisceau électronique.

**9.** Dispositif de lithographie électronique selon la revendication 8, **caractérisé en ce que** le module de calcul est configuré pour optimiser la distribution de la dose déposée dans la cible, par un calcul comportant une convolution de la fonction d'étalement du point et de la géométrie du motif à graver.

**10.** Dispositif de microscopie électronique comportant :

  - un module d'accélération et de projection d'un faisceau électronique incident sur une cible ;
  - un module d'affichage d'un signal décrivant la cible ;
  - un calculateur configuré pour optimiser une fonction d'étalement du point globale à partir de la correction des effets de diffusion des électrons incidents dans la cible ; et
  - un module de traitement du signal réémis résultant de l'interaction du faisceau électronique incident avec la cible, le module étant configuré pour corriger le signal décrivant la cible en utilisant un calcul de déconvolution du signal réémis par la cible et ladite fonction d'étalement du point globale ;

dispositif **caractérisé en ce que** la correction des effets de diffusion des électrons incidents dans la cible comporte une étape de calcul d'une fonction d'étalement du point additionnelle ayant une variation radiale suivant une fonction polynomiale par morceaux.

**Patentansprüche**

**1.** Verfahren zum Projizieren eines Elektronenstrahls auf ein Ziel, umfassend eine Korrektur der Elektronenstreueffekte in dem Ziel, **dadurch gekennzeichnet, dass** die genannte Korrektur einen Schritt zum Berechnen einer Punkt-Spread-Funktion mit einer radialen Variation gemäß einer stückweisen Polynomfunktion umfasst.

**2.** Verfahren nach Anspruch 1, **dadurch gekennzeichnet, dass** die Korrektur der Elektronenstreueffekte der Elektronen im Ziel eine Modulation der im Ziel abgelagerten Dosis umfasst.

**3.** Verfahren nach einem der Ansprüche 1 und 2, **dadurch gekennzeichnet, dass** die Korrektur der Elektronenstreueffekte der Elektronen im Ziel eine Modulation der Geometrie des Teils des Ziels umfasst, der den Elektronenstrahl empfängt.

**4.** Verfahren nach einem der Ansprüche 1 bis 3, **dadurch gekennzeichnet, dass** die radiale Variation der Punkt-Spread-Funktion ein stückweise kubisches Polynom ist.

**5.** Verfahren nach Anspruch 4, **dadurch gekennzeichnet, dass** die radiale Variation der Spread-Funktion über ein Intervall [a, b] definiert wird, das zur Menge der reellen Zahlen R gehört, sowie dadurch, dass die radiale Variation sogenannte natürliche Grenzbedingungen erfüllt, sodass die zweiten Ableitungen der radialen Variation an den Enden des Intervalls [a, b] Null sind.

**6.** Verfahren nach Anspruch 1, **dadurch gekennzeichnet, dass** die stückweise Polynomfunktion durch Koeffizienten

definiert ist ($\alpha_{i,j}$), wobei die Koeffizienten so gewählt sind, dass die Interpolation des Ergebnisses einer probabilistischen Referenzsimulation der Elektronenstreuung aus dem Elektronenstrahl in dem Ziel durch die radiale Variation der Punkt-Spread-Funktion optimiert wird.

7. Verfahren nach Anspruch 1, **dadurch gekennzeichnet, dass** die stückweise Polynomfunktion durch Koeffizienten definiert ist ($\alpha_{i,j}$), wobei die Koeffizienten so gewählt sind, dass die Interpolation experimenteller Ergebnisse, die die Elektronenstreuung aus dem Elektronenstrahl in dem Ziel darstellen, durch die radiale Variation der Punkt-Spread-Funktion optimiert wird.

8. Elektronische Lithografievorrichtung, die umfasst:

   • ein Beschleunigungs- und Projektionsmodul eines Elektronenstrahls auf ein Ziel;
   • ein Berechnungsmodul, das zum Korrigieren der Streueffekte der Elektronen in dem Ziel vorgesehen ist;

   **dadurch gekennzeichnet, dass** das Berechnungsmodul so vorgesehen ist, dass es eine Punkt-Spread-Funktion mit radialer Variation als stückweiser Polynomfunktion berechnet, um die Verteilung der abgelagerten Dosis in dem Ziel und/oder die Geometrie des Teils des Ziels zu optimieren, das den Elektronenstrahl empfängt.

9. Elektronische Lithografievorrichtung nach Anspruch 8, **dadurch gekennzeichnet, dass** das Berechnungsmodul so vorgesehen ist, dass es die Verteilung der im Ziel abgelagerten Dosis durch eine Berechnung optimiert, die eine Faltung der Punkt-Spread-Funktion und der Geometrie des zu ätzenden Mediums umfasst.

10. Elektronenmikroskopievorrichtung, die umfasst:

    - ein Modul zum Beschleunigen und Projizieren eines auf ein Ziel auftreffenden Elektronenstrahls;
    - ein Anzeigemodul für ein Signal, das das Ziel beschreibt;
    - einen Rechner, der so vorgesehen ist, dass er eine globale Punkt-Spread-Funktion ausgehend von der Korrektur der Streueffekte der auf das Ziel auftreffenden Elektronen optimiert; und
    - ein Modul zur Verarbeitung des erneut übertragenen Signals, das aus der Wechselwirkung des einfallenden Elektronenstrahls mit dem Ziel resultiert, wobei das Modul so konfiguriert ist, dass es das das Ziel beschreibende Signal unter Verwendung einer Entfaltungsberechnung des von dem Ziel erneut übertragenen Signals und der globalen Punkt-Spread-Funktion korrigiert;

    Vorrichtung, die **dadurch gekennzeichnet ist, dass** die Korrektur der Streueffekte der auf das Ziel auftreffenden Elektronen einen Schritt der Berechnung einer zusätzlichen Punkt-Spread-Funktion mit einer radialen Variation gemäß einer stückweisen Polynomfunktion umfasst.

## Claims

1. A method for projecting an electron beam onto a target comprising correction of the electron scattering effects in the target, **characterized in that** said correction comprises a step of calculating a point spread function having a radial variation according to a piecewise polynomial function.

2. The method according to claim 1, **characterized in that** correction of the electron scattering effects in the target comprises modulation of the dose deposited in the target.

3. The method according to one of claims 1 and 2, **characterized in that** correction of the electron scattering effects in the target comprises modulation of the geometry of the portion of the target receiving the electron beam.

4. The method according to one of claims 1 to 3, **characterized in that** the radial variation of the point spread function is a piecewise cubic polynomial.

5. The method according to claim 4, **characterized in that** the radial variation of the point spread function is defined over an interval [a , b] belonging to the set of real numbers $\mathbb{R}$, and **in that** the radial variation complies with the limit conditions called natural conditions so that the second derivatives of the radial variation at the ends of the interval [a, b] are zero.

6. The method according to claim 1, **characterized in that** the piecewise polynomial function is defined by coefficients ($\alpha_{i,j}$), said coefficients being chosen such as to optimize interpolation of the result of a reference probabilistic simulation of the electron scattering originating from the electron beam in the target, by the radial variation of the point spread function.

7. The method according to claim 1, **characterized in that** the piecewise polynomial function is defined by coefficients ($\alpha_{i,j}$), said coefficients being chosen such as to optimize interpolation of the experimental results representing scattering of the electrons originating from the electron beam in the target, by the radial variation of the point spread function.

8. An electron beam lithography device comprising:

   • a module for accelerating and projecting an electron beam onto a target;
   • a computing module configured to correct the electron scattering effects in said target;

   **characterized in that** the computing module is configured to calculate a point spread function having a radial variation in the form of a piecewise polynomial function so as to optimize the distribution of the dose deposited in the target and/or the geometry of the portion of the target receiving the electron beam.

9. The electron beam lithography device according to claim 8, **characterized in that** the computing module is configured to optimize the distribution of the dose deposited in the target by a calculation comprising a convolution of the point spread function and of the geometry of the pattern to be etched.

10. An electron microscopy device comprising:

   - a module for accelerating and projecting an incident electron beam onto a target;
   - a display module of a signal describing the target;
   - a computer configured to optimize a global point spread function from correction of the scattering effects of the incident electrons in the target; and
   - a processing model of the re-emitted signal resulting from the interaction of the incident electron beam with the target, the module being configured to correct the signal describing the target using a calculation of deconvolution of the signal re-emitted by the target and said global point spread function;

   **characterized in that** correction of the scattering effects of the incident electrons in the target comprises a computation step of an additional point spread function having a radial variation according to a piecewise polynomial function.

**Figure 1**

**Figure 2**

**Figure 3**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080067446 A